# EUROPEAN PATENT APPLICATION

(11) **EP 4 089 873 A1**
(43) Date of publication of application: **16.11.2022**
(21) Application number: 21184929.4
(22) Date of filing: 11.07.2021
(51) Int. Cl.: H02J 7/00

(54) **CHARGING COMPARTMENT SYSTEM AND CONTROLLING METHOD THEREOF**

(30) Priority: 21.04.2021 CN 202110430286
(71) Applicant: Jinyun Reypu Electronic Technology CO., LTD., 321403 Lishui City Zhejiang (CN); Zhejiang Okai Vehicle Co., Ltd., 321403 Lishui City Zhejiang (CN); Hangzhou Yele Technology Co., Ltd., 310000 Hangzhou Zhejiang (CN)
(72) Inventor: Lu, Jiangtao, Lishui City, 321403 (CN); Yi, Dongdong, Lishui City, 321403 (CN); Tang, Wei, Hangzhou, 310000 (CN); Du, Songxian, Lishui City, 321403 (CN); Liu, Dejun, Lishui City, 321403 (CN); Cao, Yang, Lishui City, 321403 (CN); Li, Guanglu, Lishui City, 321403 (CN); Chen, Cheng, Lishui City, 321403 (CN)
(74) Representative: Loo, Chi Ching

(57) **Abstract**

A charging compartment system and relates to a technical field of charging device, the charging compartment system includes a charging module for charging a low-power battery; a driving module for moving a battery out of or into the charging compartment; a controller electrically connected with both the charging module and the driving module. The charging compartment system further includes a detection module for detecting whether a fully charged battery is picked by a user after being moved out of the charging compartment for a period of time, if the fully charged battery is not picked, the driving module moves the fully charged battery into the charging compartment, and if the fully charged battery is picked, the controller prompts that the charging compartment is an empty charging compartment. The disclosure has technical effect that the charged battery can be ejected, and users can save time and labor when picking the battery.

## Description

### TECHNICLAL FIELD

The disclosure relates to a technical field of charging devices, in particular to a charging compartment system and a controlling method thereof.

### BACKGROUND ART

A charging cabinet is a kind of intelligent device placed in public places, and a user can put a battery with insufficient power into the charging cabinet first, then make a payment by scanning a two-dimensional code and get a battery with sufficient power, which can completely realize the self-service and intelligence.

Generally, the charging cabinet includes a plurality of charging compartments which each can store and charge a battery; however, the charging compartments are generally of open structures, with insufficient protection for the battery and ease of being lost.

A charging control method of a shared rechargeable battery cabinet and a shared rechargeable battery cabinet are disclosed in Chinese invention application No. CN108922051A published on Nov, 30, 2018, which protect the battery with a door lock detection module and a door lock control module, and improves a cooperation stability between the battery and the charging unit compartment with the battery lock control module, with a disadvantage that an extraction of the battery is required to be made completely by the user when the user picks the battery, which is time consuming and labour intensive.

### SUMMARY

### 1. Problems to be solved

In view of a technical problem that it is time-consuming and labour intensive for a user to pick a battery in a charging compartment, the disclosure provides a charging compartment system and a controlling method of the charging compartment system, which can eject the charged batteries and save time and labor when the user picks the battery.

### 2. Solution

To solve the above problems, the technical scheme provided in the disclosure is as follows:
A charging compartment system includes:
a charging module for charging a low-power battery;
a driving module for moving a battery out of or into a charging compartment;
a controller electrically connected with both the charging module and the driving module; and
a communication module for realizing a mutual signal transmission among the controller, the charging module and the driving module.

The charging compartment system further includes a detection module for detecting whether a fully charged battery is picked by a user after being moved out of the charging compartment for a period of time, if the fully charged battery is not picked, the driving module moving the fully charged battery into the charging compartment, and if the fully charged battery is picked, the controller prompting that the charging compartment is an empty charging compartment.

Optionally, the charging compartment system further includes a limiting module for limiting a driving stroke of the driving module. The limiting module is electrically connected with the controller.

Optionally, the charging compartment system further includes an identification module. The identification module is configured for identifying information about the low-power battery and judging whether the low-power battery is matched, and the identification module is electrically connected with the controller.

Optionally, the information about the low-state battery includes battery brand, battery model, battery capacity, battery BMS information, battery power, battery temperature, charging current, battery cycle times, battery health degree and battery voltage.

Optionally, the charging compartment system further includes a locking module. The locking module is configured for locking the low-power battery or locking the fully charged battery, and the locking module is electrically connected with the controller.

Optionally, the locking module is an electronic lock, and the electronic lock is electrically connected with the controller.

A controlling method includes following steps S1 to S3:
In S1, a user puts a low-power battery into an empty charging compartment, and an identification module judges whether the low-power battery is matched; if the low-power battery is matched, the low-power battery is electrically connected with a charging module, and a locking module is triggered to lock the low-power battery and a normal charging is started until the charging is complete; if the low-power battery is not matched, a driving module moves the low-power battery out of the charging compartment, and a limiting module is triggered during the driving process to limit a driving stroke of the driving module.

In S2, after the low-power battery starts to be charged normally, the driving module of the charging compartment with the full-power battery drives the full-power battery to move out of the charging compartment for the user's picking, and the limiting module is triggered during the driving process to limit the driving stroke of the driving module.

In S3, after a period of time, the detection module detects whether the fully charged battery is picked by the user after being moved out of the charging compartment for a period of time; if the fully charged battery is not picked, the driving module moves the fully charged battery into the charging compartment, the limiting module is triggered during the driving process to limit the driving stroke of the driving module, and the locking module is triggered to lock the fully charged battery; if the fully charged battery is picked by the user, the controller prompts that the charging compartment is an empty charging compartment.

Optionally, an identification method of the identification module is to identify by inputting an identification code of the low-power battery or by scanning an identification pattern of the low-power battery.

Optionally, a limiting method of the limiting module is to limit the driving stroke of the driving module through a limiting sensor.

### 3. Beneficial effects

Compared with the prior art, the technical scheme provided in the disclosure has beneficial effects that the charged battery can be ejected, and users can save time and labor when picking the battery.

### BRIEF DESCRIPTION OF THE DRAWINGS

Fig.1 is a schematic diagram of a charging compartment system according to an embodiment of the present disclosure; and
Fig. 2 is a schematic diagram of a controlling method of a charging compartment according to an embodiment of the present disclosure.

In the drawings: 1. Charging Compartment; 11. Controller; 12. Charging Module; 13. Driving Module; 14. Limiting Module; 15. Identification Module; 16. Locking Module; 17. Detection Module; 18. Communication Module.

### DETAILED DESCRIPTION

In order to further understand contents of the present disclosure, the present disclosure will be described in detail with reference to drawings and examples.

The application will be further described in detail with reference to the drawings and embodiments. It can be understood that the specific embodiments described herein are only intended to explain related disclosures, but not to limit the disclosure. In addition, it should also be noted that for convenience of description, only the parts related to the disclosure are shown in the drawings. Terms such as "first" and "second" mentioned in the present disclosure are provided for the convenience of describing the technical scheme of the present disclosure, have no specific limiting function, are all general terms and do not constitute a limiting for the technical scheme of the present disclosure. It should be noted that the embodiments in the present application and the characteristics in the embodiments can be combined mutually in the case of no conflict. In the description of the present disclosure, it should be understood that the terms "center", "upper", "lower", "left", "right", "vertical", "horizontal", "inner" and "outer" which indicate an orientation or positional relationship are based on the orientation or positional relationship shown in the drawings, and are merely for convenience of describing the present disclosure and simplifying the description, rather than indicate or imply that the device or element referred to must have a specific orientation, be configured and operated in a specific orientation, and thus cannot be understood as a limitation on the present disclosure. In addition, the terms "first", "second" and "third" are only configured for descriptive purposes and cannot be understood as indicating or implying a relative importance. Unless otherwise specified and limited, the terms "installing", "coupling" and "connecting" should be understood in a broad sense, for example, it can be "fixedly connecting", or "detachably connecting" or "integrally connecting", or it can be "mechanically connecting" or "electrically connecting", or it can be "directly connecting" or "indirectly connecting through an intermediate medium", or it can be "communicating within two elements". For a person of ordinary skill in the art, specific meanings of the above terms in the present disclosure can be understood according to specific situations.

### Embodiment 1

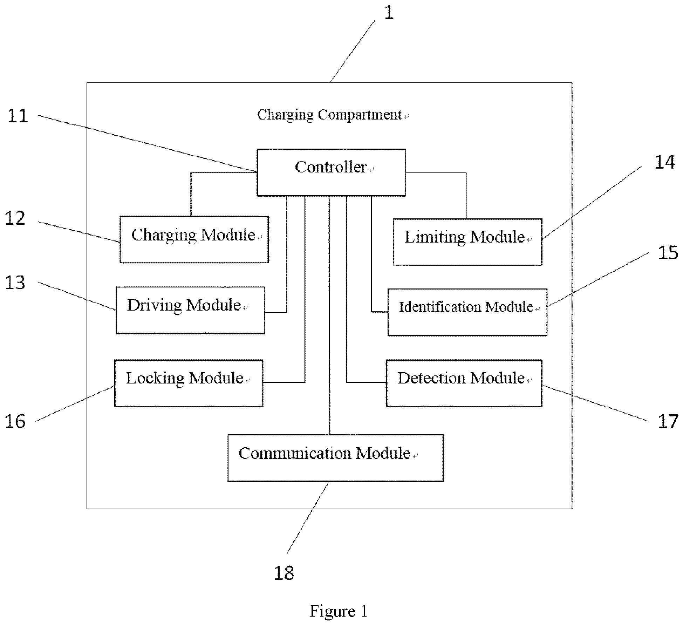

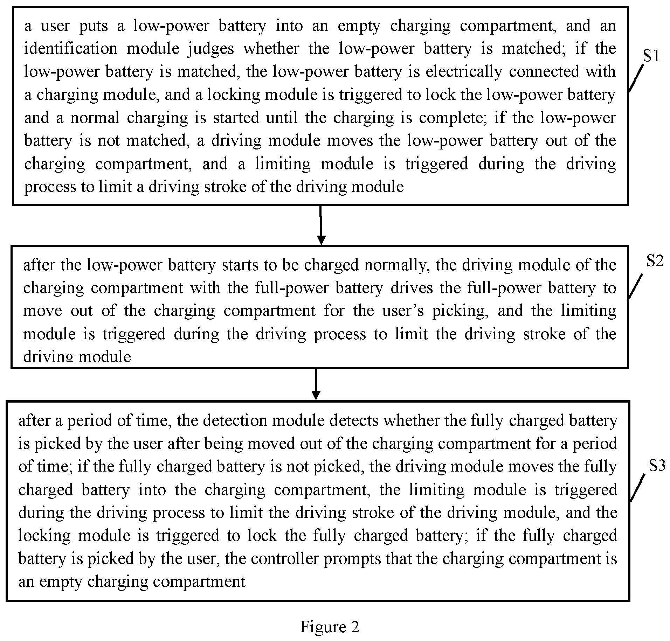

With reference to Figs.1 to 2, the present disclosure provides a charging compartment system including:
a charging module 12 for charging a low-power battery;
a driving module 13 for moving a battery out of or into a charging compartment 1;
a controller 11 electrically connected with both the charging module 12 and the driving module 13; and
a communication module 18 for realizing a mutual signal transmission among the controller 11, the charging module 12 and the driving module 13.

Specifically, when the battery needs to be replaced, firstly, the user puts the low-state battery to be replaced into an empty charging compartment 1, the low-state battery is electrically connected with the charging module 12 which then starts charging the low-state battery until the low-state battery is completely charged to be a fully-charged battery; and the charging module 12 transmits a signal to the controller 11 and the controller 11 controls the charging module 12 to disconnect from the fully-charged battery.

When the low-state battery starts to be charged normally, the controller 11 of the charging compartment 1 with the full-state battery gets a signal, and the controller 11 controls the driving module 13 to move the full-state battery out of the charging compartment 1, thereby saving time and effort when the user picks the full-state battery.

Specifically, the charging compartment system further includes a detection module 17 for detecting whether a fully charged battery is picked by a user after being moved out of the charging compartment 1 for a period of time, and if the fully charged battery is not picked, the driving module 13 moves the fully charged battery into the charging compartment 1; and if the fully charged battery is picked, the controller 11 prompts that the charging compartment is an empty charging compartment 1.

The detection module 17 is configured for detecting whether the fully charged battery is picked by a user after being moved out of the charging compartment 1 for a period of time, and if the fully charged battery is not picked, the detection module 17 transmits a signal to the controller 11, and the controller 11 transmits a signal to the driving module 13 to move the fully charged battery into the charging compartment 1 so as to prevent the fully charged battery from being lost and effectively protect the fully charged battery; and if the fully charged battery is picked, the detection module 17 transmits a signal to the controller 11, and the controller 11 prompts that the charging compartment 1 is an empty charging compartment 1. The communication module 18 is configured for realizing a mutual signal transmission between the controller 11 and the detection module 17.

Specifically, the charging compartment system further includes a limiting module 14 for limiting a driving stroke of the driving module 13. The limiting module 14 is electrically connected with the controller 11.

In a process of moving the fully charged battery by the driving module 13 out of the charging compartment 1, the limiting module 14 is triggered so that the limiting module 14 transmits a signal to the controller 11, and the controller 11 controls the driving module 13 to stop driving to prevent the fully charged battery from falling out of the charging compartment 1 and causing damage to the battery; and in a process of moving the fully charged battery by the driving module 13 into the charging compartment 1, the limiting module 14 is triggered so that the limiting module 14 transmits a signal to the controller 11, and the controller 11 controls the driving module 13 to stop driving so as to prevent the driving module 13 from reciprocating for a long distance and resulting in a failure of the driving module 13. The communication module 18 is configured for realizing a mutual signal transmission between the controller 11 and the limiting module 14.

Specifically, the charging compartment system further includes an identification module 15. The identification module 15 is configured for identifying information about the low-power battery and judging whether the low-power battery is matched, and the identification module 15 is electrically connected with the controller 11.

If the identification module 15 judges that the low-power battery is not matched, the identification module 15 transmits a signal to the controller 11, and the controller 11 controls the driving module 13 to move the low-power battery out of the charging compartment 1; and if the identification module 15 judges that the low-power battery is matched, the low-state battery is electrically connected with the charging module 12 which then starts charging the low-state battery until the low-state battery is completely charged to be a fully-charged battery; and the charging module 12 transmits a signal to the controller 11 and the controller 11 controls the charging module 12 to disconnect from the fully-charged battery. The communication module 18 is configured for realizing a mutual signal transmission between the controller 11 and the identification module 15.

Specifically, the information about the low-state battery includes battery brand, battery model, battery capacity, battery BMS information, battery power, battery temperature, charging current, battery cycle times, battery health degree and battery voltage.

The battery brand, battery model and battery capacity are mainly used to judge whether the battery is compatible with the charging compartment 1; The battery BMS information, battery power, battery temperature, charging current, battery cycle times, battery health degree level and battery voltage are mainly used to judge whether the battery fails. Only when two conditions, namely being compatible and without failure, are met, the identification module 15 will determine that the battery are matched.

Specifically, the charging compartment system further includes a locking module 16. The locking module 16 is configured for locking the low-power battery or locking the fully charged battery, and the locking module 16 is electrically connected with the controller 11.

During a cooperating of the low-power battery and the charging module 12, the low-power battery triggers the locking module 16 which transmits a signal to the controller 11, and the controller 11 controls the locking module 16 to lock the low-power battery to prevent the low-power battery from being lost; in a process that the fully charged battery is returned to the charging compartment 1, the fully charged battery triggers the locking module 16 which transmits a signal to the controller 11, and the controller 11 controls the locking module 16 to lock the fully charged battery to prevent it from being lost. The communication module 18 is configured for realizing a mutual signal transmission between the controller 11 and the locking module 16.

Specifically, the locking module 16 is an electronic lock, which is electrically connected with the controller 11. The electronic lock can be unlocked and locked automatically by the controller 11, which makes the charging compartment system more intelligent.

The disclosure also provides a controlling method of a charging compartment system including S1 to S3.

In S1, a user puts a low-power battery into an empty charging compartment 1, and an identification module 15 judges whether the low-power battery is matched; if the low-power battery is matched, the low-power battery is electrically connected with a charging module 12, and a locking module 16 is triggered to lock the low-power battery and a normal charging is started until the charging is complete; if the low-power battery is not matched, a driving module 13 moves the low-power battery out of the charging compartment 1, and a limiting module 14 is triggered during the driving process to limit a driving stroke of the driving module 13.

In S2, after the low-power battery starts to be charged normally, the driving module 13 of the charging compartment 1 with the full-power battery drives the full-power battery to move out of the charging compartment 1 for the user's picking, and the limiting module 14 is triggered during the driving process to limit the driving stroke of the driving module 13.

In S3, after a period of time, the detection module detects whether the fully charged battery is picked by the user after being moved out of the charging compartment 1 for a period of time; if the fully charged battery is not picked, the driving module 13 moves the fully charged battery into the charging compartment 1, the limiting module 14 is triggered during the driving process to limit the driving stroke of the driving module 13, and the locking module 16 is triggered to lock the fully charged battery; if the fully charged battery is picked by the user, the controller 11 prompts that the charging compartment 1 is an empty charging compartment 1.

Specifically, when the battery needs to be replaced, firstly, the user puts the low-state battery to be replaced into the empty charging compartment 1, and the identification module 15 judges whether the low-state battery is matched, and if the low-state battery is matched, the low-state battery is electrically connected with the charging module 12 and the locking module 16 is triggered to transmit a signal to the controller 11and the controller 11 controls the locking module 16 to lock the low-power battery and prevent the low-power battery from being lost and effectively protect it, then the charging module 12 starts charging the low-power battery until the low-state battery is completely charged to be a fully-charged battery, then the charging module 12 transmits a signal to the controller 11 and the controller 11 controls the charging module 12 to disconnect from the full-power battery; if the low-state battery is not matched, the identification module 15 transmits a signal to the controller 11 and the controller 11 controls the driving module 13 to move the low-state battery out of the charging compartment 1, the limiting module 14 is triggered during the driving process to transmit a signal to the controller 11 and the controller 11 controls the driving module 13 to stop driving, the limiting module 14 plays a role in limiting the driving stroke of the driving module 13, thereby preventing the low-state battery from being excessively displaced, causing the low-state battery to fall out of the charging compartment 1 and causing damage to the low-state battery.

When the low-power battery starts to be charged normally, the controller 11 of the charging compartment 1 with the full-power battery get a signal; the controller 11 controls the driving module 13 to drive the full-power battery to move out of the charging compartment 1 for the user's picking; the limiting module 14 is triggered during the driving to transmit a signal to the controller 11 and the controller 11 control the driving module 13 to stop driving, the limiting module 14 plays a role in limiting the driving stroke of the driving module 13, so as to prevent the full-power battery from being excessively displaced, causing the full-power battery to fall out of the charging compartment 1 and causing damage to the full-power battery.

After a period of time, the detection module 17 detects whether the fully charged battery is picked by the user after being moved out of the charging compartment 1 for a period of time; if the fully charged battery is not picked, the detection module 17 transmits a signal to the controller 11 and the controller 11 controls the driving module 13 to move the fully charged battery into the charging compartment 1, the limiting module 14 is triggered during the driving to transmit a signal to the controller 11 and the controller 11 control the driving module 13 to stop driving, the limiting module 14 plays a role in limiting the driving stroke of the driving module 13 so as to prevent the full-power battery from being excessively displaced, causing the full-power battery to fall out of the charging compartment 1 and causing damage to the full-power battery, and then the locking module 16 is triggered to transmit a signal to the controller 11 and the controller 11 controls the locking module 16 to lock the low-power battery and prevent the low-power battery from being lost and effectively protect it; if the fully charged battery is picked, the controller 11 prompts that the charging compartment 1 is an empty charging compartment 1.

Specifically, an identification method of the identification module 15 is to identify by inputting an identification code of the low-power battery or by scanning an identification pattern of the low-power battery.

The identification method of the identification module 15 is as follows: the identification code of the low-state battery is input and the controller 11 obtains the information about the low-state battery to judge whether the low-state battery is matched or not; or the identification pattern of the low-state battery is scanned and the controller 11 obtains the information about the low-state battery to judge whether the low-state battery is matched or not. When the identification pattern cannot be scanned, the identification code can be manually input to improve fault tolerance rate of the charging compartment system.

Specifically, a limiting method of the limiting module 14 is to limit the driving stroke of the driving module 13 through a limiting sensor.

When the driving module 13 drives for a certain distance to one end, a limit sensor is triggered to transmit a signal to the controller 11, and the controller 11 controls the driving module 13 to stop driving; when the driving module 13 is driven for a certain distance to the other end, another limit sensor is triggered to transmit a signal to the controller 11 and the controller 11 controls the driving module 13 to stop driving. Therefore, the driving stroke of the driving module 13 can be effectively limited by the two limit sensors.

The present disclosure and embodiments thereof are described above in an illustrative manner, which is not restrictive; and what is shown in the drawings is only one of the embodiments of the present disclosure, and its actual structure is not limited thereto. Therefore, structures and embodiments similar to the technical scheme designed by those of ordinary skills in the art inspired by this disclosure without creativity, without departing from the creative purpose of the present disclosure, are all within a protection scope of the present disclosure.

## Claims

1. A charging compartment system, comprising:
a charging module for charging a low-power battery;
a driving module for moving a battery out of or into a charging compartment;
a controller electrically connected with both the charging module and the driving module; and
a communication module for realizing a mutual signal transmission among the controller, the charging module and the driving module.

2. The charging compartment system according to claim 1, further comprising a detection module, wherein the detection module for detecting whether a fully charged battery is picked by a user after being moved out of the charging compartment for a period of time, if the fully charged battery is not picked, the driving module moving the fully charged battery into the charging compartment, and if the fully charged battery is picked, the controller prompting that the charging compartment is an empty charging compartment.

3. The charging compartment system according to claim 1, further comprising a limiting module for limiting a driving stroke of the driving module, the limiting module being electrically connected with the controller.

4. The charging cabinet system according to claim 1, further comprising an identification module, the identification module being configured for identifying information about the low-power battery and judging whether the low-power battery is matched, and the identification module being electrically connected with the controller.

5. The charging compartment system according to claim 4, wherein the information about the low-state battery comprises battery brand, battery model, battery capacity, battery BMS information, battery power, battery temperature, charging current, battery cycle times, battery health degree and battery voltage.

6. The charging compartment system according to claim 1, further comprising a locking module, the locking module being configured for locking the low-power battery or locking the fully charged battery, and the locking module being electrically connected with the controller.

7. The charging compartment system according to claim 6, wherein the locking module is an electronic lock, the electronic lock being electrically connected with the controller.

8. A controlling method of the charging compartment system according to any one of claims 1 to 7, wherein the method comprises S1 to S3:
in S1, a user puts a low-power battery into an empty charging compartment, and an identification module judges whether the low-power battery is matched; if the low-power battery is matched, the low-power battery is electrically connected with a charging module, and a locking module is triggered to lock the low-power battery and a normal charging is started until the charging is complete; if the low-power battery is not matched, a driving module moves the low-power battery out of the charging compartment, and a limiting module is triggered during the driving process to limit a driving stroke of the driving module;
In S2, after the low-power battery starts to be charged normally, the driving module of the charging compartment with the full-power battery drives the full-power battery to move out of the charging compartment for the user's picking, and the limiting module is triggered during the driving process to limit the driving stroke of the driving module; and
In S3, after a period of time, the detection module detects whether the fully charged battery is picked by the user after being moved out of the charging compartment for a period of time; if the fully charged battery is not picked, the driving module moves the fully charged battery into the charging compartment, the limiting module is triggered during the driving process to limit the driving stroke of the driving module, and the locking module is triggered to lock the fully charged battery; if the fully charged battery is picked by the user, the controller prompts that the charging compartment is an empty charging compartment.

9. The controlling method of the charging compartment system according to claim 8, wherein an identification method of the identification module is to identify by inputting an identification code of the low-power battery or by scanning an identification pattern of the low-power battery.

10. The controlling method of the charging compartment system according to claim 8, wherein a limiting method of the limiting module is to limit the driving stroke of the driving module through a limiting sensor.
